(19) Europäisches Patentamt
European Patent Office
Office européen des brevets

(11) Numéro de publication: **0 300 394 B1**

(12) **FASCICULE DE BREVET EUROPEEN**

(45) Date de publication de fascicule du brevet: **29.04.92**

(51) Int. Cl.$^5$: **G06F 15/74**

(21) Numéro de dépôt: **88111477.1**

(22) Date de dépôt: **16.07.88**

(54) **Dispositif d'acquisition et de traitement de données.**

(30) Priorité: **20.07.87 FR 8710346**

(43) Date de publication de la demande:
**25.01.89 Bulletin 89/04**

(45) Mention de la délivrance du brevet:
**29.04.92 Bulletin 92/18**

(84) Etats contractants désignés:
**AT BE CH DE GB IT LI NL SE**

(56) Documents cités:
**GB-A- 2 102 169**
**US-A- 4 473 889**

**AUTOTESTCON '78, INTERNATIONAL AUTOMATIC TESTING CONFERENCE, San Diego, CA, 28-30 novembre 1978, pages 63-70, IEEE, New York, US; H.A. GOLDSTAND: "Software techniques for a microprocessor-based data acquisition device"**

(73) Titulaire: **ELECTRICITE NEUCHATELOISE S.A.**
**Les Vernets**
**CH-2035 Corcelles(CH)**

(72) Inventeur: **Dänzer, Pierre**
**Rue des Saars 21**
**CH-2000 Neuchâtel(CH)**

(74) Mandataire: **de Raemy, Jacques et al**
**ICB Ingénieurs Conseils en Brevets SA Passage Max. Meuron 6**
**CH-2001 Neuchâtel(CH)**

**EP 0 300 394 B1**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services
(-/2.18/2.0)

## Description

La présente invention concerne un dispositif pour acquérir et traiter au moins une grandeur physique se présentant sous la forme d'un signal électrique, dispositif comprenant au moins un circuit adaptateur ramenant le signal électrique à une valeur prédéterminée, un microprocesseur traitant ledit signal selon au moins un programme, ledit microprocesseur présentant une entrée et une sortie auxiliaire unique reliée à un connecteur, une alimentation reliée à une source d'énergie extérieure, au moins une mémoire-programme contenant les programmes de traitement, ladite mémoire-programme étant chargée via l'entrée auxiliaire du microprocesseur au moyen d'un ordinateur, au moins une mémoire-résultat apte à emmagasiner les résultats dudit traitement et à délivrer, sur demande, lesdits résultats à l'ordinateur, et/ou à un affichage, et/ou à une imprimante, reliés à la sortie auxiliaire du microprocesseur, une base de temps fournissant au moins la date et l'heure pour, d'une part, déclencher le traitement du signal aux périodes horaires introduites dans la mémoire-programme et, d'autre part, définir la date et l'heure correspondant aux résultats emmagasinés dans la mémoirerésultat, ladite base de temps étant susceptible d'être remise à l'heure via l'entrée auxiliaire du microprocesseur, et une source d'alimentation autonome.

De nombreux dispositifs ont déjà été proposés pour acquérir et traiter une grandeur physique se présentant sous la forme d'un signal électrique.

On peut mentionner d'abord des moyens simples et bon marché tel qu'un ampèremètre à aiguille traînante par exemple, qui permet l'enregistrement d'une valeur maximum de courant. Ce moyen se limite à l'enregistrement d'une seule valeur par période d'observation.

On trouve également des enregistreurs à bande de papier se déroulant de façon continue. Ce moyen est coûteux car il demande un dépouillement qui est long et fastidieux. De plus, il ne permet pas un enregistrement clair de phénomènes fugitifs le plus souvent très rapides qui nécessiteraient, pour donner de bons résultats, d'élargir l'échelle temps inscrite sur le papier. Cette méthode rend aussi très difficile la comparaison de deux phénomènes se produisant à un même moment à des endroits différents.

Il existe aussi des enregistreurs digitaux utilisant des bandes magnétiques. Il s'agit là d'un appareil cher, mécaniquement fragile. Dans ce genre d'appareil, on notera de surcroît que la comparaison entre deux points de mesure séparés géographiquement n'est pas possible sans comparer les bases de temps des appareils et donc de les relier pour procéder à la mesure. De plus toute lecture à distance est impossible.

Le document GB-A-2 102 169 décrit enfin un appareil d'acquisition de données issues d'instruments de mesure à aiguille permettant d'enregistrer la consommation d'énergie en gaz ou en électricité. On utilise ici un capteur photoélectrique qui rend compte du nombre de passages de l'aiguille de l'instrument indicateur devant le capteur en fonction du temps. Les données sont emmagasinées digitalement dans une mémoire organisée en deux unités, une première unité commandée par un microprocesseur faisant partie de l'appareil et une seconde unité étant capable être chargée avec les données de la première, puis détachée de l'appareil et couplée à un analyseur. Ainsi, pendant l'analyse des données de la seconde unité, l'appareil continue à délivrer des données à la première unité de mémoire.

Le dispositif défini dans le premier paragraphe de cette description diffère du document cité en ce qu'il comprend :

a) une base de temps susceptible d'être remise à l'heure, via l'entrée auxiliaire du microprocesseur, par un ordinateur. On fera remarquer cependant que le document cité comporte une base de temps fournissant au moins la date et l'heure et qu'une base de temps remise à l'heure périodiquement par un ordinateur central ou "master" est connu du document US-A-4 473 889.

b) une mémoire-programme chargée, via l'entrée auxiliaire du microprocesseur, par un ordinateur. On fera cependant remarquer que le document cité comporte implicitement une telle mémoire pour assurer le fonctionnement du microprocesseur. D'autre part, le chargement sur une station éloignée de programmes de traitement est une technique bien connue en informatique. Ce peut être une ligne de transmission ou une cassette portable que l'on connecte à la station, comme cela est décrit dans le document "Autotestcon '78, International Automatic Testing Conference, San Diego, CA, 28-30 novembre 1978, pages 63-70, IEEE, New York, US; H.A. Goldstand : "Software techniques for a microprocessor-based data acquisition device".

c) une source d'alimentation autonome. Or, une telle source d'alimentation autonome, venant en complément d'une alimentation reliée à une source extérieure est également décrite dans le document "Autotescon '78" cité ci-dessus.

Cependant, aucun des documents cités ne décrit ni ne suggère le caractère principal de la présente invention à savoir que le dispositif est réalisé en deux unités séparables, cette disposition présentant l'avantage de charger la mémoire-programme et/ou de lire la mémoire-résultat non pas sur place, à l'endroit de la mesure, mais dans un bureau d'exploitation.

En plus de cela, le dispositif selon l'invention apporte une solution à deux problèmes auxquels est confronté un chef d'exploitation quand il s'agit d'acquérir et de traiter des données issues par exemple d'un réseau d'énergie électrique : si toutes les données sont enregistrées, il sera submergé de papier et s'il limite le nombre de ces données, il est possible que celles dont il aura besoin ne figureront pas sur l'enregistrement.

Pour apporter une solution à ces problèmes et pour remédier aux inconvénients présentés par les appareils de l'art antérieur le dispositif selon la présente invention présente les améliorations suivantes:

- le signal est traité de façon à réduire les enregistrements aux caractéristiques essentielles: on n'enregistre que ce qui est intéressant,
- un même signal peut être traité en même temps de plusieurs façons différentes afin de pouvoir en évaluer aussi bien les évolutions lentes que les phénomènes fugitifs généralement très rapides,
- le dispositif est organisé de telle façon qu'on peut vérifier très simplement la simultanéité des événements (mémoires et base de temps liées comme on le verra par la suite),
- la lecture à distance est possible.

Ainsi, le dispositif selon la présente invention, en plus qu'il répond à la définition générique donnée au premier paragraphe de cette description, est-il caractérisé par le fait que ledit circuit adaptateur, ledit microprocesseur et ladite alimentation reliée à une source d'énergie extérieure constituent une première unité et que ladite mémoire-programme, ladite mémoire-résultat, ladite base de temps et ladite source d'alimentation autonome constituent une seconde unité, lesdites première et seconde unités étant arrangées pour être séparables l'une de l'autre et embrochables l'une sur l'autre, ladite seconde unité étant embrochable à nouveau sur une autre première unité en conservant les informations contenues dans ses mémoires et dans sa base de temps.

L'invention sera comprise maintenant à la lecture de la description qui suit, illustrée à titre d'exemple par le dessin qui l'accompagne.

La figure unique montre un schéma préféré du dispositif d'acquisition et de traitement des données selon l'invention.

Comme on le voit sur la figure, le dispositif selon l'invention comprend essentiellement une première unité 2 et une seconde unité 9, séparables grâce aux connecteurs référencés 17, 18 et 19.

La première unité 2 comporte une ou plusieurs bornes d'entrée 20, 20', etc, qui reçoivent chacune un signal 1, 1', etc, qu'il s'agit de traiter. Ces signaux sont ceux qu'on peut s'attendre à trouver par exemple dans un réseau d'énergie électrique. Cependant ce pourrait être d'autres signaux électriques correspondant par exemple à une température, à une pression barométrique, à une vitesse du vent et la présente invention n'est pas limitée à son application à un réseau électrique.

Dans l'application qui est prise en exemple ici, les signaux se présentent sous forme de tensions ou de courants analogiques, alternatifs ou continus, tous proportionnels aux grandeurs primaires qui peuvent être des tensions, des courants, des puissances actives ou réactives, des énergies, etc. Ce pourrait être aussi des signaux digitaux (impulsions) correspondant aux grandeurs primaires énumérées ci-dessus.

Connecté à la borne d'entrée 20, on trouve un circuit adaptateur 3 qui ramène le signal électrique 1 à une valeur prédéterminée 4 à la sortie de l'adaptateur. Dans un exemple d'exécution le signal est ramené à une valeur ne dépassant pas ± 2,5 V (valeur de fin d'échelle). L'adaptateur présenté ici est un diviseur potentiométrique, mais on pourrait aussi utiliser un transformateur pour les signaux alternatifs.

Un microprocesseur 5 reçoit sur ses entrées 21, 21', etc, les signaux 4, 4', etc, présents à la sortie des adaptateurs correspondants en vue de leur traitement ultérieur. On peut envisager plusieurs types de microprocesseur, notamment celui portant la référence M 8097 BH. Le microprocesseur est relié à un connecteur auxiliaire 6 d'entrée et de sortie unique auquel peuvent être reliés un ordinateur personnel 11 (PC), une imprimante 14 et un affichage 13, tous situés en dehors de l'unité 1 ou à une liaison pour lecture à distance.

L'unité 2 comporte encore une alimentation 7 reliée à une source d'énergie extérieure 8 dans le but d'alimenter notamment le microprocesseur 5.

La seconde unité 9 comprend au moins une mémoire-programme 10 qui contient le ou les programmes de traitement. Cette mémoire 10 est chargée au moyen de l'ordinateur 11 via l'entrée auxiliaire 6 du microprocesseur 5. Le chargement du ou des programmes de traitement peut se faire au moyen d'une disquette fournie avec le système. Ce chargement peut se faire sur place, c'est-à-dire à l'endroit où s'opèrent les mesures ou à l'avance dans un bureau d'exploitation. Dans ce dernier cas on utilisera une unité auxiliaire 2 qui permette ledit chargement, puis on transportera l'unité 9 qu'on enfichera sur l'unité 2 située sur place.

La seconde unité 9 comprend encore au moins une mémoire-résultat 12 apte à emmagasiner les résultats du traitement en provenance du microprocesseur 5. Cette mémoire-résultat délivre, sur demande, lesdits résultats via la sortie 6 du microprocesseur 5 à l'ordinateur 11, et/ou à l'affichage 13, et/ou à l'imprimante 14. Ces résultats sont lus par l'intermédiaire d'un interface non représenté qui peut être du type RS 232, puis mis en mémoire sur disquette. Comme c'était le cas lors de l'opération de chargement de la mémoire-programme, la lecture peut se faire sur place au moyen des unités 2 et 9 présentes à l'endroit de la mesure ou encore au bureau d'exploitation à l'aide d'une première unité 2 auxiliaire et de l'unité 9. Il est à noter que cette lecture peut aussi se faire à distance par l'intermédiaire d'un modem.

Les mémoires 10 et 12 peuvent être du type RAM 8k x 8 / 32k x 8 LP qui sont obtenables couramment dans le commerce.

La seconde unité 9 comprend aussi une base de temps 15 fournissant au moins la date et l'heure. Il peut s'agir d'un oscillateur à quartz suivi d'un diviseur de fréquence. La base de temps est utilisée pour déclencher le traitement du signal aux périodes horaires introduites dans la première mémoire 10. La période de mesure peut être indéfinie ou limitée à certaines heures de la journée, certains jours de la semaine et/ou compris entre deux dates précises. Tous les cas particuliers peuvent être envisagés, par exemple mesurer un départ uniquement le troisième mercredi du mois. S'il est désiré un enregistrement mensuel, à chaque mois correspond un programme ne différant des autres que par les dates de mise en et hors service. La base de temps 15 est utilisée également pour définir la date et l'heure correspondant aux résultats emmagasinés dans la mémoire-résultat 12 lors de la lecture de ces résultats. On notera enfin que la base de temps 15 peut être remise à l'heure via l'entrée 6 du microprocesseur 5.

Enfin la seconde unité 9 comporte une source d'alimentation autonome 16. Il peut s'agir d'une batterie rechargeable. Cette alimentation assure la conservation complète des informations contenues dans les mémoires ainsi que le maintien de l'heure quand la seconde unité 9 est débranchée de la première unité 2. En conséquence de ce qui a été expliqué ci-dessus, on notera généralement que:

- la première unité 2 fait l'acquisition de chaque valeur et la traite selon un programme spécifique ou, si nécessaire, selon plusieurs programmes; l'affichage 13, branché à la sortie 6 peut afficher les valeurs primaires d'entrée présentes aux bornes 20, 20', etc,
- la seconde unité 9 fournit les programmes de traitement à la première unité 2 à partir de la mémoire de programme 10 et enregistre les valeurs dans la mémoire de résultats 12; ainsi sont emmagasinés dans la mémoire de résultats 12, les valeurs en fonction du programme choisi, les événements particuliers avec la date et l'heure, par exemple un dépassement d'une valeur de consigne avec l'instant de ce dépassement, sa valeur maximale et sa durée; au besoin l'imprimante 14 peut enregistrer les événements particuliers au fur et à mesure de leur apparition,
- l'ordinateur 11 (PC) charge les programmes spécifiques sur chaque seconde unité 9. De même il lit et enregistre, sur disquette par exemple, les valeurs acquises.

On notera que l'exploitation des enregistrements se fait selon les besoins de l'entreprise par un programme adapté (affichage sur écran, protocoles, etc).

En plus des avantages mentionnés dans le préambule de cette description, on appréciera que, à l'exception des adaptateurs 3, le hardware est identique pour toutes les unités décrites, ce qui conduit à un appareil bon marché. Toutes les particularités d'un problème sont reportées sur le software qui est établi selon les désirs de l'utilisateur.

On donnera ci-après quatre exemples d'utilisation du dispositif selon l'invention illustrés chacun par un tableau correspondant délivré par l'imprimante liée au système. Dans ces tableaux l'indication MED désigne la première unité 2 et l'indication MEM la seconde unité 9.

1) Premier exemple: statistique des écarts de tension.

On établit un programme pour mémoriser, par classes de valeur et de durée, les écarts d'une grandeur par rapport à Sa valeur nominale. Le tableau 1 montre une statistique des écarts de tension d'une ligne à 60 kV. La mesure est faite à la station de Marin 60 et dans les conditions indiquées en tête du tableau. Pour prendre un exemple, le 1 entouré d'un cercle indique que la tension de 60 kV a baissé entre les 40 et 70 % de sa valeur et ceci pendant une durée comprise entre 100 et 500 ms, ceci une seule fois pendant la période d'enregistrement.

2. Deuxième exemple: courbe de la puissance active.

Ce programme permet de mémoriser des valeurs moyennes et extrêmes au lieu et dans les conditions indiqués en tête des tableaux 2.1 et 2.2.

La grandeur mesurée est intégrée pendant une période choisie de chaque journée. Le résultat est utilisé pour le calcul de la valeur moyenne pour la période considérée. Simultanément, les valeurs extrêmes de cette grandeur sont comparées à celles obtenues précédemment. Si un nouveau maximum ou minimum est atteint, il est mémorisé.

Le tableau 2.1 montre la puissance moyenne sous forme d'un histogramme sur lequel figurent également les valeurs maximum et minimum de puissance. Ainsi pour prendre un exemple, la mesure 006 indique qu'entre 2 heures 30 min. et 3 heures, la puissance moyenne de tous les jours compris entre le 2 et 31 janvier a été de 100 kW (référence A), la puissance minimum de 80 kW (référence B) et la puissance maximum de 135 kW (référence C), les puissances maximum et minimum étant intégrées pendant une durée de 2 minutes pendant la demi-heure considérée.

Le tableau 2.2 reprend toutes les valeurs enregistrées sous la forme d'un tableau. Pour la mesure 006 correspondant à celle considérée ci-dessus, le tableau indique avec plus de précision les valeurs ci-dessus, soit 103,5 kW pour la valeur moyenne, 84,7 kW pour la valeur minimum et 136, 9 kW pour la valeur maximum. Le tableau 2.2 donne de surcroît la date et l'heure auxquelles ont été lues les valeurs minimum et maximum soit respectivement le 25 janvier 1987 à 2h59min et le 10 janvier 1987 à 2h56min. Comme il est souvent intéressant de connaître la valeur atteinte par la puissance réactive lorsque la puissance active atteint une valeur extrême, le programme offre aussi la possibilité d'effectuer un tel enregistrement. C'est ainsi qu'à 84,7 kW correspond 40,8 kVar et à 136,9 kW correspond 70,3 kVar.

L'exemple choisi montre que la durée de l'enregistrement peut être limitée dans le temps à:

- une certaine époque de l'année (ici janvier 1987, avec mise en service de l'enregistreur le 2 janvier),
- une partie de la semaine (ici 5 jours ouvrables, du lundi au vendredi),
- une partie de la journée (ici 24 heures sur 24).

3. Troisième exemple: Valeur des écarts de tension (valeurs fugitives).

Certains incidents doivent être mémorisés précisément avec l'heure du début, la valeur maximale ou minimale atteinte et leur durée, pour pouvoir en trouver la cause ou vérifier leur simultanéité en différents points du réseau.

Le programme utilisé dans ce troisième exemple permet ces mesures qui sont consignées dans le tableau 3. Ici est présenté le résultat d'un enregistrement des variations instantanées de la tension lorsque celle-ci s'écarte de la valeur nominale en dehors d'une plage choisie à priori (ici en dehors de ± 10 %). Le tableau est suffisamment explicite et il n'est pas nécessaire de le commenter.

On remarquera que dans ce programme, comme dans celui utilisé à propos du premier exemple d'ailleurs, l'enregistrement des valeurs a lieu lorsqu'il y a dépassement d'un ou de plusieurs seuils (ici ± 10 % de la tension nominale).

4. Quatrième exemple: Pointes de charges journalières.

Le programme permet de connaître chaque jour l'heure de la consommation maximum avec indication de la puissance active et réactive et du cos $\phi$ correspondant. Le tableau 4 illustre un tel genre de mesure.

**Tableau 1**

Station : MARIN 60
Départ : CORNAUX
Phase(s) : R & S
Période : 24 heures par jour,
les 7emes jours des semaines,
du 02/01/87 à 09:30:02 (1)
au 12/06/87 à 16:00:10 (2)
Valeur(s): Valeur(s) efficace(s)

**** STATISTIQUE DES ECARTS DE TENSION ****

Tension nominale ( = 100 % ): 60'000 [V]

| Durée de l'écart [s] ---> | 00.01 à 00.10 | 0.1 à 0.5 | 0.5 à 1.0 | 1.0 à 3.0 | 3.0 à 20. | 20. à 60. | > 60. | Totaux |
|---|---|---|---|---|---|---|---|---|
| 90 - 70 % | 5 | 0 | 0 | 0 | 0 | 0 | 1 | 7 |
| 70 - 40 % | 6 | 1 | 0 | 0 | 1 | 1 | 0 | 9 |
| 40 - 01 % | 0 | 0 | 0 | 0 | 0 | 0 | 0 | 0 |
| 00 % | 3 | 3 | 5 | 0 | 0 | 0 | 0 | 11 |
| Totaux | 14 | 4 | 5 | 0 | 1 | 1 | 1 | 28 |
| > 110 % | 12 | 5 | 2 | 2 | 10 | 0 | 3 | 34 |

**Remarques : MED No 005 / MEM No 115**

**Arrêts du MED :** (3)
**a) du 26/02/87 à 05:45:34 au 26/02/87 à 06:00:23**
**b) du 03/04/87 à 14:05:23 au 03/04/87 à 18:21:21**
**c) du 04/04/87 à 23:56:43 au 05/04/87 à 00:56:08**

**(1) : Début de l'enregistrement**
**(2) : Fin de l'enregistrement**
**(3) : Arrêts de la mesure dûs à l'interruption de l'alimentation de l'appareil**

## Tableau 2.1

| | |
|---|---|
| Station | : MARIN 60 |
| Départ | : LES SUGIEZ |
| Phase(s) | : - |
| Période | : 24 heures par jour, des 2èmes aux 6emes jours des semaines, du 02/01/87 à 09:30:02 (1) au 31/01/87 à 24:00:00 (2) |
| Intégration | : 30 minutes (pour valeurs moy.) 2 minutes (pour valeurs min./max.) 2 minutes (pour valeurs second.) |
| Valeur(s) | : Valeur(s) moyenne(s) |

**** COURBE DE LA PUISSANCE ACTIVE ****
(courbe de charge -- partie gauche)

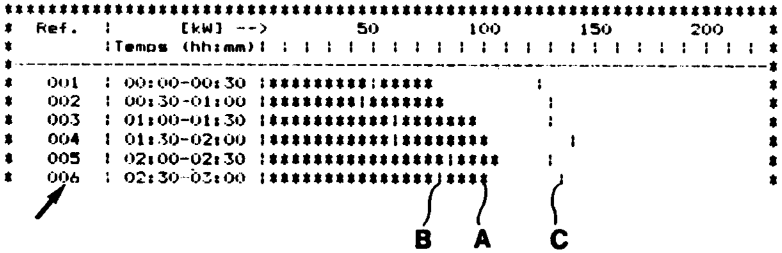


Remarques : MED No 005 / MEM No 115
Arrêts du MED : (3)
a) du 26/02/87 à 05:45:34 au 26/02/87 à 06:00:23
b) du 03/04/87 à 14:05:23 au 03/04/87 à 18:21:21
c) du 04/04/87 à 23:56:43 au 05/04/87 à 00:56:08

(1) : Début de l'enregistrement
(2) : Fin de l'enregistrement
(3) : Arrêts de la mesure dûs à l'interruption de l'alimentation de l'appareil

## Tableau 2.2

| | |
|---|---|
| Station | : MARIN 60 |
| Départ | : LES SUGIEZ |
| Phase(s) | : - |
| Période | : 24 heures par jour, des 2èmes aux 6emes jours des semaines, du 02/01/87 à 09:30:02 (1) au 31/01/87 à 24:00:00 (2) |
| Intégration | : 30 minutes (pour valeurs moy.) 2 minutes (pour valeurs min./max.) 2 minutes (pour valeurs second.) |
| Valeur(s) | : Valeur(s) moyenne(s) |

**** COURBE DE LA PUISSANCE ACTIVE ****
(courbe de charge -- partie droite)

| Ref. | Valeur moy. | Valeur min. Date | Heure | [kW] | [kVar] | Valeur max. Date | Heure | [kW] | [kVar] |
|---|---|---|---|---|---|---|---|---|---|
| 001 | 75.3 | 03/01/87 | 00:02 | 50.0 | 30.1 | 16/01/87 | 00:28 | 123.4 | 65.6 |
| 002 | 79.8 | 25/01/87 | 00:40 | 47.2 | 29.5 | 06/01/87 | 00:31 | 127.8 | 66.7 |
| 003 | 98.9 | 15/01/87 | 01:24 | 59.8 | 35.8 | 26/01/87 | 01:15 | 130.1 | 68.8 |
| 004 | 106.3 | 10/01/87 | 01:55 | 62.2 | 36.0 | 26/01/87 | 01:51 | 136.5 | 69.9 |
| 005 | 111.2 | 25/01/87 | 02:08 | 87.6 | 42.2 | 10/01/87 | 02:24 | 132.4 | 68.9 |
| 006 | 103.5 | 25/01/87 | 02:59 | 84.7 | 40.8 | 10/01/87 | 02:56 | 136.9 | 70.3 |

Remarques : MED No 005 / MEM No 115
Arrêts du MED : (3)
a) du 26/02/87 à 05:45:34 au 26/02/87 à 06:00:23
b) du 03/04/87 à 14:05:23 au 03/04/87 à 18:21:21
c) du 04/04/87 à 23:56:43 au 05/04/87 à 00:56:08

(1) : Début de l'enregistrement
(2) : Fin de l'enregistrement
(3) : Arrêts de la mesure dûs à l'interruption de l'alimentation de l'appareil

**Tableau 3**

```
Station   : MARIN 60
Départ    : CORNAUX
Phase(s)  : R
Période   : 24 heures par jour,
            les 7emes jours des semaines,
            du 03/01/87 à 17:15:15.5          (1)
            au 12/06/87 à 16:00:10.7          (2)
Valeur(s) : Tension efficace
Critère   : > 90 % ou < 110 %
```

****** TABLEAU DES ECARTS DE TENSION ******

ECARTS DE TENSION (3)

Tension nominale ( = 100 % ): 60'000 [V]

| Date JJ/MM/AA | Début hh:mm:ss.s | Durée hh:mm:ss.s | Valeur max/min |
|---|---|---|---|
| 11/06/87 | 15:15:15.5 | 00:00:01.5 | 68 % |
| 05/05/87 | 15:18:19.0 | 00:24:30.5 | 00 % |
| 05/05/87 | 02:10:10.0 | 00:00:00.5 | 88 % |
| 04/05/87 | 02:10:51.1 | 00:01:01.1 | 00 % |
| 03/05/87 | 17:15:15.5 | 00:03:56.6 | 43 % |

Remarques : MED No 005 / MEM No 115

Arrêts du MED : (3)

a) du 04/04/87 à 23:56:43 au 05/04/87 à 00:56:08

b) du 03/04/87 à 14:05:23 au 03/04/87 à 18:21:21

c) du 26/02/87 à 05:45:34 au 26/02/87 à 06:00:23

(1) : Enregistrement le plus ancien

(2) : Arrêt de l'enregistrement

(3) : Ordre chronologique inverse

```
***********************************************************************
*                                                                     *
*                                                                     *
*         Station      : MARIN 60                      Tableau 4      *
*         Départ       : TRANSFORMATEUR 60/16.5 [kV]                  *
*         Phase(s)     : RST                                          *
*         Période      : 24 heures par jour,                          *
*                        tous les jours,                              *
*                        du 20/12/86 à 09:30:02               (1)     *
*                        au 02/04/87 à 15:00:08               (2)     *
*         Intégration : 0.1 secondes                                  *
*                                                                     *
*                                                                     *
***********************************************************************
*                                                                     *
*          **** POINTES DE CHARGES JOURNALIERES ****                   *
*                                                                     *
***********************************************************************
*     Date          Heure          [kW]        [kVar]       cos phi   *
*---------------------------------------------------------------------*
*     20/12/86      11:28          123.4        65.6         0.88     *
*     21/12/86      11:20          127.8        66.7         0.88     *
*     22/12/86      11:45          130.1        68.8         0.85     *
*     23/12/86      11:51          136.5        69.9         0.89     *
*     24/12/86      11:34          132.4        68.9         0.89     *
*     25/12/86      11:56          136.9        70.3         0.89     *
```

```
***********************************************************************
*                                                                     *
*                                                                     *
*     Remarques : MED No 005 / MEM No 115                             *
*     Arrêts du MED :                                         (3)     *
*     a) du 26/02/87 à 05:45:34 au 26/02/87 à 06:00:23                *
*     b) du 03/03/87 à 14:05:23 au 03/03/87 à 18:21:21                *
*     c) du 04/03/87 à 23:56:43 au 05/03/87 à 00:56:08                *
*                                                                     *
*                                                                     *
***********************************************************************
*                                                                     *
*     (1) : Début de l'enregistrement                                 *
*     (2) : Fin de l'enregistrement                                   *
*     (3) : Arrêts de la mesure dûs à l'interruption de               *
*           l'alimentation de l'appareil                              *
*                                                                     *
***********************************************************************
```

## Revendications

1. Dispositif pour acquérir et traiter au moins une grandeur physique se présentant sous la forme d'un signal électrique (1), dispositif comprenant au moins un circuit adaptateur (3) ramenant le signal électrique à une valeur prédéterminée (4), un microprocesseur (5) traitant ledit signal selon au moins un programme, ledit microprocesseur présentant une entrée et une sortie auxiliaire unique reliée à un connecteur (6), une alimentation (7) reliée à une source d'énergie extérieure (8), au moins une mémoire-programme (10) contenant les programmes de traitement, au moins une mémoire-résultat (12) apte à emmagasiner les résultats dudit traitement et à délivrer, sur demande, lesdits résultats à l'ordinateur, et/ou à un affichage (13), et/ou à une imprimante (14), reliés à la sortie auxiliaire du microprocesseur, une base de temps (15) fournissant au moins la date et l'heure pour, d'une part, déclencher le traitement du signal aux périodes horaires introduites dans la mémoire-programme et, d'autre part, définir la date et l'heure correspondant aux résultats emmagasinés dans la mémoire-résultat, et une source d'alimentation autonome (16) caractérisé par le fait que ladite mémoire-programme est chargée via l'entrée auxiliaire du microprocesseur au moyen d'un ordinateur (11), ladite base de temps est susceptible d'être remise à l'heure via l'entrée auxiliaire du microprocesseur, et par le fait que ledit circuit adaptateur (3), ledit microprocesseur (5) et ladite alimentation (7) reliée à une source d'énergie extérieure (8) constituent une première unité (2) et que ladite mémoire-programme (10), ladite mémoire-résultat (12), ladite base de temps (15) et ladite source d'alimentation autonome (16) constituent une seconde unité (9), lesdites première et seconde unités étant arrangées pour être séparables l'une de l'autre, et embrochables l'une sur l'autre, ladite seconde unité étant embrochable à nouveau sur une autre première unité en conservant les informations contenues dans ses mémoires (10, 12) et dans sa base de temps (15).

**Claims**

1. Device for the acquisition and processing of at least one physical magnitude appearing in the form of an electrical signal (1), such device comprising at least one adapter circuit (3) bringing the electrical signal back to a predetermined value (4), a microprocessor (5) processing said signal in accordance with at least one program, said microprocessor showing a unique auxiliary input and output coupled to a connector (6), a power supply (7) coupled to an external energy source (8), at least one program memory (10) containing the processing programs, at least one result memory (12) adapted to store the results of said processing and to furnish, on request, said results to the computer, and/or to a display (13), and/or to a printer (14), such being coupled to the auxiliary output of the microprocessor, a time base (15) furnishing at least the date and the time of day in order, on the one hand, to trigger processing of the signal at the time periods introduced into the program memory and, on the other hand, to define the date and the time of day corresponding to the results stored in the result memory, and an autonomous power source (16), characterized in that said program memory is loaded via the auxiliary input of the microprocessor by means of a computer (11), said time base is adapted to be reset to the time of day via the auxiliary input of the microprocessor and in that said adapter circuit (3), said microprocessor (5) and said power supply (7) coupled to an external energy source (8) constitute a first unit (2) and that said program memory (10), said result memory (12), said time base (15) and said autonomous power source (16) constitute a second unit (9), said first and second units being arranged so as to be separable from one another and pluggable into one another, said second unit being again pluggable into another first unit while preserving the information contained in its memories (10,12) and in its time base (15).

**Patentansprüche**

1. Vorrichtung zur Erfassung und Verarbeitung von zumindest einer physikalischen Größe, die in Form eines elektrischen Signals (1) auftritt, wobei diese Vorrichtung zumindest eine Anpassungsschaltung (3) umfaßt, die das elektrische Signal auf einen vorbestimmten Wert (4) zurücksetzt, einen Mikroprozessor (5), der das Signal gemäß zumindest einem Programm verarbeitet, wobei dieser Mikroprozessor einen einzigen mit einem Stecker (6) verbundenen Nebenein- und - ausgang besitzt, eine Stromversorgung (7), die mit einer externen Energiequelle (8) verbunden ist, zumindest einen Programmspeicher (10), der die Verarbeitungsprogramme enthält, zumindest einen Ergebnisspeicher (12), der die Ergebnisse der Verarbeitung speichern und auf Verlangen diese Ergebnisse an den Computer und/oder an ein Display (13) abgeben kann, und/oder einen Drucker (14), die an den Nebenausgang des Mikroprozessors angeschlossen sind, eine Zeitbasis (15), die zumindest Datum und Uhrzeit liefert, um einerseits die Verarbeitung des Signals zu den in den Programmspeicher eingegebenen Zeiten auszulösen und andererseits Datum und Uhrzeit zu bestimmen, die den im Ergebnisspeicher gespeicherten Resultaten entsprechen und eine autonome Stromversorgungsquelle (16), eine Vorrichtung, die durch die Tatsache gekennzeichnet ist, daß der Programmspeicher über den Nebeneingang des Mikroprozessors mit Hilfe eines Computers (11) geladen wird, daß die Zeiteinstellung der Zeitbasis über den Nebeneingang des Mikroprozessors erfolgen kann und durch die Tatsache, daß die Anpassungsschaltung (3), der Mikroprozessor (5) und die an eine äußere Energiequelle (8) angeschlossene Stromversorgung (7) eine erste Einheit (2) bilden, und daß der Programmspeicher (10), der Ergebnisspeicher (12), die Zeitbasis (15) und die autonome Stromversorgungsquelle (16) eine zweite Einheit (9) bilden, und die erste und die zweite Einheit so angeordnet sind, daß sie voneinander trennbar und aufeinander steckbar sind, wobei die zweite Einheit neuerlich auf eine andere erste Einheit aufgesteckt werden kann und dabei die in ihren Speichern (10, 12) und in ihrer Zeitbasis (15) enthaltenen Daten nicht gelöscht werden.

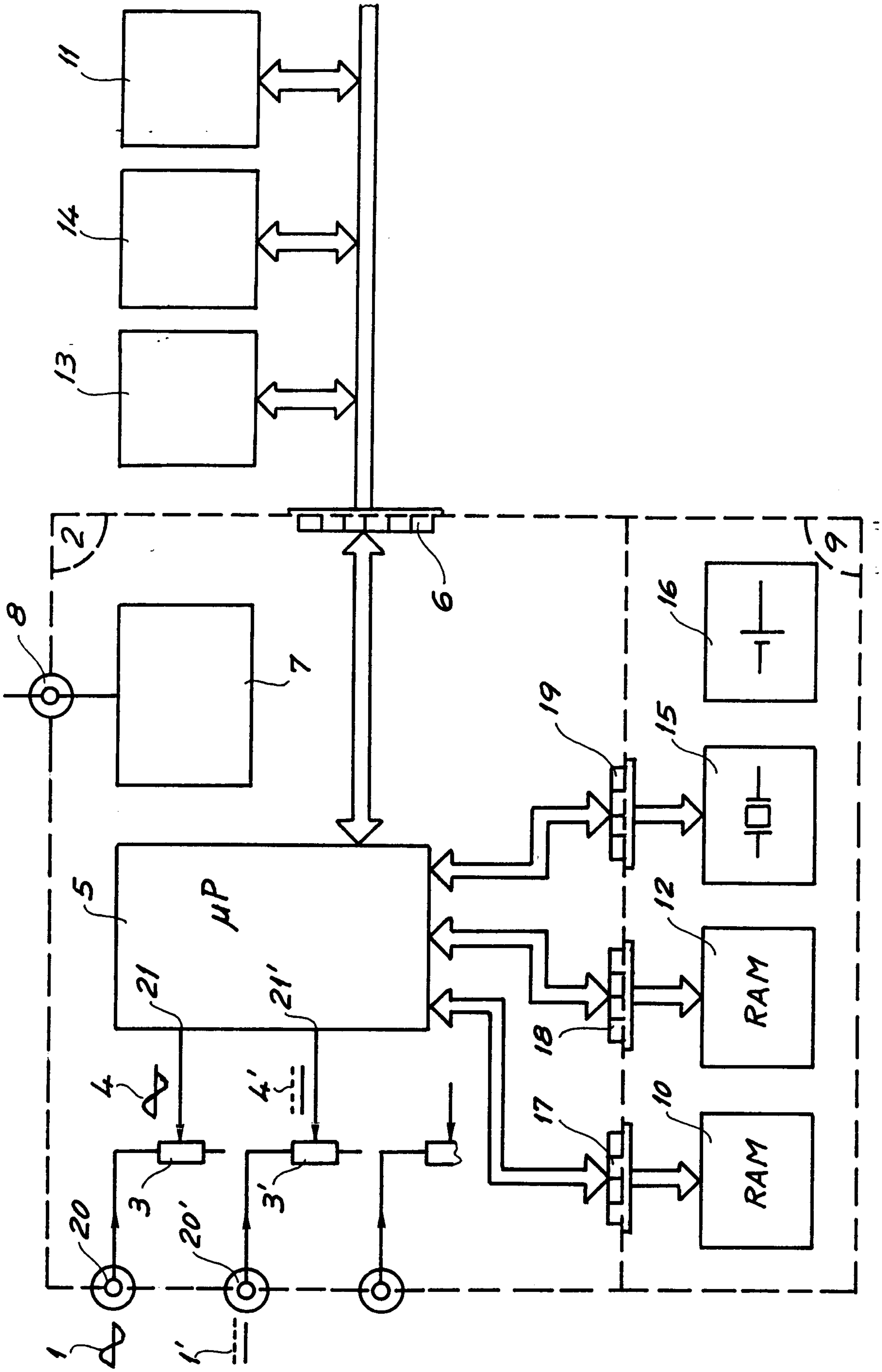
µP
RAM
RAM